Europäisches Patentamt

European Patent Office

Office européen des brevets

(19)

(11) EP 0 463 598 B1

(12) **FASCICULE DE BREVET EUROPEEN**

(45) Date de publication et mention
de la délivrance du brevet:
**13.03.1996 Bulletin 1996/11**

(51) Int Cl.6: **H03M 13/12**

(21) Numéro de dépôt: **91110393.5**

(22) Date de dépôt: **24.06.1991**

(54) **Circuit de décodage de codes convolutionnels pour l'exécution de l'étape de stockage et d'exploration inverse des chemins survivants d'un algorithme de viterbi**

Konvolutionalcode-Decodierungsschaltung zur Durchführung des Speicher- und Zurückverfolgungsschritts der überlebenden Pfade eines Viterbi-Algorithmus

Convultional code decoding circuit performing the viterbi algorithm step of memorisation and backtracing of the surviving paths

(84) Etats contractants désignés:
**CH DE ES FR GB IT LI NL SE**

(30) Priorité: **28.06.1990 FR 9008178**

(43) Date de publication de la demande:
**02.01.1992 Bulletin 1992/01**

(73) Titulaires:
• **ALCATEL TELSPACE**
  **F-92734 Nanterre Cédex (FR)**
  Etats contractants désignés:
  **DE ES FR GB IT NL SE**
• **ALCATEL N.V.**
  **NL-1077 XX Amsterdam (NL)**
  Etats contractants désignés:
  **CH LI**

(72) Inventeurs:
• **Bazet, André**
  **F-92110 Clichy (FR)**
• **Sadot, Philippe**
  **F-75011 Paris (FR)**

(74) Mandataire: **Weinmiller, Jürgen et al**
  **Lennéstrasse 9**
  **Postfach 24**
  **D-82336 Feldafing (DE)**

(56) Documents cités:
**US-A- 4 536 878**

• **SIXTH INTERNATIONAL CONFERENCE ON DIGITAL SATELLITE COMMUNICATIONS; 19-23 September 1983 Phoenix, Arizona, USA pages 16 - 23; J. S. SNYDER: "High speed Viterbi decoding of high-rate codes"**
• **INTEGRATION, THE VLSI JOURNAL. vol. 8, no. 1, octobre 1989, AMSTERDAM NL pages 3 - 16; M. BIVIER et al.: "Architectural design and realization of a single- chip Viterbi decoder"**
• **FUJITSU-SCIENTIFIC AND TECHNICAL JOURNAL. vol. 25, no. 1, mars 1989, KAWASAKI JP pages 37 - 43; A: YAMASHITA et al.: "A new path memory for Viterbi decoders"**
• **IBM TECHNICAL DISCLOSURE BULLETIN. vol. 31, no. 7, décembre 1988, NEW YORK US pages 476 - 481; "Difference metric decoder for interleaved biphase trellis code"**
• **PATENT ABSTRACTS OF JAPAN vol. 10, no. 91 (E-394)(2148) 09 avril 1986, & JP-A- 60 235529 (FUJITSU K.K.) 22 novembre 1985,**
• **IEEE TRANSACTIONS ON COMMUNICATIONS. vol. 29, no. 9, septembre 1981, NEW YORK US pages 1399 - 1401; C.M. RADER: "Memory management in a Viterbi decoder"**

**Description**

Le domaine de la présente invention est celui du codage/décodage des codes convolutionnels.

Essentiellement, les codes convolutionnels (également appelés codes convolutifs ou codes récurrents) sont des codes générés à partir d'une suite de données numériques appliquées, sous forme d'un train de bits successifs, en entrée d'un codeur, ces données étant convoluées par des polynômes générateurs et les opérations étant toujours effectuées modulo 2. Une telle convolution peut être réalisée de façon simple au moyen d'un codeur comprenant un registre formé d'une série de ν bascules D dont les sorties respectives sont combinées par des portes selon une configuration particulière, spécifique du codage que l'on souhaite effectuer, et donnant en sortie un train d'informations binaires codées. Les bascules sont montées en registre à décalage, de sorte que le codage d'un bit d'information courant dépend non seulement de la valeur du bit d'entrée courant mais également de la valeur des ν bits antérieurs.

Un tel codeur peut être considéré comme un automate à nombre fini d'états, dont les états internes et les transitions entre états peuvent être représentés sous la forme d'un treillis. Un chemin dans ce treillis général représentera une séquence codée, analogue d'un mot de code.

Ces différents aspects de la question sont développés notamment dans l'ouvrage de A.J. Viterbi et J.K Omura, *Principes des communications numériques* (traduction G. Battail), Dunod, 1982, ainsi que dans les ouvrages de R.E. Blahut, *Theory and Practice of Error Control Codes*, Addison-Westley, 1984 et J.C. Bic, B. Duponteil et J.C. Imbeaux, *Éléments de communications numériques,* Dunod, 1986, qui exposent de façon très complète et approfondie ces principes de codage par codes convolutionnels.

L'opération de codage d'un train numérique consiste donc à parcourir l'un des chemins possibles du treillis, chaque nouveau bit du train d'information déterminant une branche du chemin et provoquant l'émission simultanée de bits (« bits de parité ») correspondant à la branche suivie.

Les trains de bits de parité sont ensuite émis sur un canal de transmission et parviennent à un récepteur et à son décodeur.

Les trains de parité reçus vont cependant comporter un certain nombre d'erreurs, produites par des défauts de transmission (bruit, brouillage, etc. ).

Le décodage en réception consistera donc, à partir du train de bits de parité reçu, entaché de bruit, à reconstituer le chemin du treillis effectivement décrit par le codeur à l'émission et ainsi retrouver la séquence des bits d'information ayant provoqué, au niveau du codage, le parcours de ce chemin.

Le procédé le plus performant pour effectuer un tel décodage d'un train numérique bruité est connu sous la dénomination d'« algorithme de Viterbi», qui est l'algorithme de décodage du type à maximum de vraisemblance.

Essentiellement, dans une première étape de cet algorithme, on compare tous les trains de parité correspondant à tous les chemins possibles du treillis aux trains effectivement reçus et on calcule pour chacun une distance entre deux bits de parité reçus et les bits correspondants de chaque branche. Cette distance, intégrée sur la longueur des branches du chemin, définit une «métrique de branche».

L'étape suivante de l'algorithme de Viterbi consiste à déterminer une « métrique de chemin » qui sera la somme des métriques des branches correspondant à un chemin donné puis, parmi tous les chemins ainsi analysés, à ne retenir que celui possédant la métrique la plus faible.

Ainsi, pour chaque couple de bits de parité reçus, le nombre de chemins possibles va doubler, ou plus (il sera multiplié par n si le code est de rendement 1/n, mais n-1 chemins seront éliminés). Il restera ainsi à chaque étape un nombre constant de chemins à prolonger; ces chemins seront appelés « chemins survivants ».

Chaque prolongation d'un chemin se traduit par le choix de l'une de n branches possibles, et ce choix est caractérisé par un bit qui correspond en fait au bit d'information qui a été nécessaire pour faire effectuer au codeur la transition retenue - c'est-à-dire le bit correspondant de l'information originelle que l'on cherche à reconstituer.

L'étape finale de l'algorithme de Viterbi est celle consistant à stocker les chemins survivants ainsi obtenus et à les explorer en sens inverse, c'est-à-dire en partant de l'instant le plus récent pour aller vers les instants antérieurs, pour n'en retenir qu'un seul, qui correspondra à l'information recherchée (ou, plus exactement, à une estimation optimale - au sens du maximum du vraisemblance - de la séquence originelle émise).

Cette étape, qui est celle qu'exécute le circuit de la présente invention, est couramment appelé « étape de *traceback* » dans la technique.

Diverses réalisations, matérielles et logicielles, ont été proposées pour mettre en oeuvre cette fonction.

L'objet de la présente invention est de proposer une structure particulière de circuit permettant d'exécuter à grande vitesse, par matériel, cette étape de l'algorithme, permettant ainsi de traiter en temps réel un flux incident de données à débit élevé.

Le principe du traceback, en lui-même connu, implique de conserver en mémoire les chemins survivants précédemment déterminés, mais en ne conservant en fait ces chemins que sur le nombre de branches ou ils sont différents, ce nombre étant appelé « longueur de troncature » L.

En effet, comme les chemins survivants ne diffèrent en fait que sur leurs L dernières branches, si on les remonte au-delà d'un certain nombre de branches, ils convergent tous vers un chemin unique ne présentant aucune ambiguïté à lever.

Le stockage est effectué dans une mémoire de profondeur 3, contenant 3L mots de N bits (N = 2$^\nu$ étant le nombre d'états du treillis et L étant la longueur de troncature pour le code considéré).

Parmi ces trois blocs, l'un est utilisé en écriture et les deux autres en lecture ; lorsque le bloc en écriture est plein il passe en lecture, et celui des blocs en lecture qui est le plus ancien à avoir été rempli repasse en écriture, et ainsi de suite.

À chaque fois que l'on écrit un mot dans la mémoire, on en lit deux en même temps (c'est-à-dire que la lecture se fait deux fois plus vite que l'écriture), de sorte que le système de lecture des chemins remonte les chemins sur deux longueurs de troncature.

Au bout de L noeuds, le chemin remonté aura rejoint le point de convergence de tous les chemins, et le chemin remonté sur la deuxième longueur de troncature sera donc bien le chemin unique recherché, pour lequel on pourra prendre sans ambiguïté une décision quant à la reconstitution des bits émis.

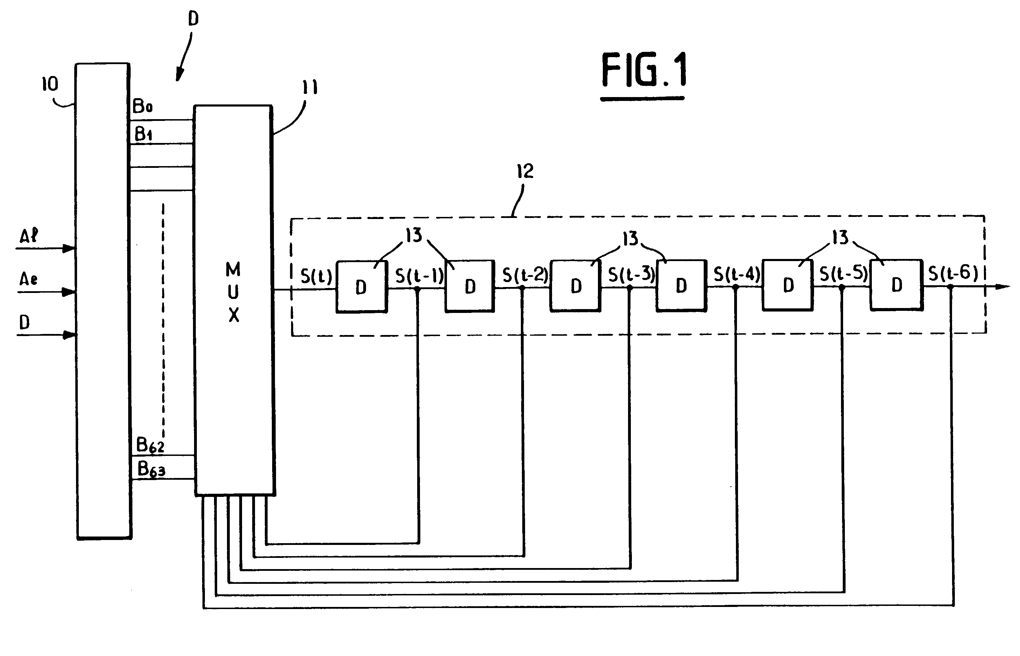

L'implantation matérielle proposée jusqu'à présent pour mettre en oeuvre par matériel cette étape a été illustrée schématiquement figure 1.

La mémoire contenant les trois blocs de L mots de N bits a été représenté en 10 ; elle reçoit en entrée les données D, les adresses de lecture $A_l$ et les adresses d'écriture $A_e$.

En sortie, la mémoire 10 délivre des mots D, formés de 2$^\nu$ bits, que l'on peut noter :

$$D = B_0, B_1 \ldots B_i \ldots B_{2^\nu - 1}.$$

Le bit $B_i$ du mot de donnée D représente la décision concernant le noeud i. Si l'on écrit i en binaire, sa valeur sera représentée par un mot de $\nu$ bits, noté par exemple :

$$i = \{A_{\nu-1} \; A_{\nu-2} \ldots A_0\}.$$

Dans l'exemple qui va suivre, on prendra $\nu = 6$, c'est-à-dire N = 2$^6$ = 64, qui est une valeur couramment utilisée (mais en aucune façon limitative).

Les mots D sont alors formés des bits $B_i$ :

$$D = B_0, B_1 \ldots B_i \ldots B_{63}.$$

L'indice i pouvant être alors représenté par un mot de six bits de la forme :

$$i = \{A_5 \; A_4 \ldots A_0\}.$$

Comme le i$^{\text{ème}}$ bit $B_i$ correspond au bit d'information qui sort du codeur pour atteindre le noeud de rang i du treillis à partir d'un noeud j de l'étape précédente, il est aisé de connaître ce noeud antécédent j : son numéro sera obtenu simplement en divisant par deux le numéro du noeud de départ et en lui ajoutant le bit $B_i$ multiplié par 2$^{\nu-1}$ :

$$j = i/2 + B_i \cdot 2^{\nu-1}$$

Comme N = 2$^\nu$, le numéro i est codé sur $\nu$ bits que l'on peut ranger dans un registre à décalage. L'opération que l'on vient d'indiquer consistera donc simplement en un décalage à droite du registre et en l'admission du bit $B_i$ en entrée du registre dans la bascule la plus à gauche de celui-ci, c'est-à-dire dans celle portant le bit de poids le plus fort.

A cet effet, dans l'implantation matérielle jusqu'à présent proposée (figure 1), on appliquait les bits $B_0$, $B_1$... aux 2$^\nu$ entrées d'un multiplexeur 2$^\nu$-en-1 (dans l'exemple cité, multiplexeur 64-en-1, référencé 11 sur la figure) délivrant en sortie un bit S(t), qui sera le bit $B_i$ sélectionné, à l'adresse de lecture appliquée à la mémoire 10, à l'instant t grâce au multiplexeur commandé par le mot {S(t-1), ... S(t-$\nu$)} (c'est-à-dire le mot de six bits {S(t-1), ... S(t-6)}, dans l'exemple considéré).

Ce schéma utilise un registre à décalage 12, que l'on appellera par la suite « registre de traceback », comprenant $\nu$ bascules 13 montées en cascade ($\nu = 6$ bascules, dans l'exemple considéré) délivrant chacune l'un des bits du mot de commande du multiplexeur, et la dernière bascule délivrant le bit d'information recherché (avec un retard, inhérent à l'algorithme, de $\nu$ étapes).

Cette implantation, malgré son apparente simplicité matérielle, présente le grave inconvénient que, lorsque $\nu$ prend des valeurs assez élevées (par exemple $\nu = 6$, comme dans l'exemple considéré) l'opération de multiplexage est assez longue et limite la vitesse maximale de fonctionnement de ce système.

En effet, comme il s'agit d'un système bouclé, celui-ci sera très sensible aux retards internes (retard d'origine matérielle, essentiellement dûs au multiplexeur et dépendant donc de la technologie employée), et le débit des données en entrée sera nécessairement limité à une cadence compatible avec l'ensemble de ces retards internes, cumulés.

Le but de la présente invention est de proposer une nouvelle architecture matérielle de mise en oeuvre de l'algorithme de traceback qui permette de s'affranchir de ce retard de multiplexage très pénalisant, et permettre donc un gain en vitesse de l'exécution de cette fonction de traceback.

Le circuit de l'invention est un circuit du type précité, c'est-à-dire un circuit de décodage de codes convolutionnels pour l'exécution de l'étape d'un algorithme de Viterbi consistant à explorer en sens inverse une pluralité de chemins d'un treillis représentatif d'un diagramme des transitions possibles résultant d'un codage par un codeur à $\nu$ bascules, chaque noeud du treillis étant représenté par un mot de N = 2$^\nu$ bits, ce circuit opérant de manière à sélectionner, parmi une pluralité de chemins survivants possibles, celui présentant la métrique la plus faible, de manière à reconstituer ainsi le chemin du treillis effectivement décrit lors du codage et retrouver la séquence de bits d'information ayant provoqué le parcours de ce chemin.

Essentiellement, l'invention propose de répartir l'opération de multiplexage en plusieurs multiplexages plus simples, disposés entre les bascules du registre à décalage, en d'autres termes en imbriquant les circuits de multiplexage et les étages du registre de traceback, au lieu de se contenter de placer en bloc ce registre en aval d'un multiplexeur, comme on l'avait jusqu'à présent proposé.

Le registre de traceback va donc présenter une structure répartie, avec au moins un circuit de multiplexage intercalé entre deux étages consécutifs de ce registre.

On verra qu'une telle architecture permet de n'utiliser que des multiplexeurs beaucoup plus simples, donc plus rapides.

Dans un premier mode de réalisation, le circuit de décodage selon l'invention comprend :

- une mémoire stockant une pluralité desdits mots de $N = 2^\nu$ bits, et

- en sortie de cette mémoire, un montage en cascade de $\nu$ groupes de multiplexeurs 2-en-1, réduisant progressivement les $2^\nu$ sorties de la mémoire en une sortie unique, une bascule D étant disposée en sortie de chaque multiplexeur,

la dernière bascule, unique, la plus en aval délivrant séquentiellement les bits d'information correspondant au chemin recherché, et le signal de sélection de chaque multiplexeur étant directement donné par la sortie de cette dernière bascule.

Dans un second mode de réalisation, le circuit de décodage selon l'invention comprend :

- une mémoire stockant une pluralité desdits mots de $N = 2^\nu$ bits sous forme de N/M blocs sélectionnables distincts de M bits chacun, M étant un sous-multiple de N de la forme $M = 2^\mu$, les sorties de chaque bloc étant appliqués sur un bus commun de M bits de large,

- un circuit sélecteur, pour sélectionner l'un desdits blocs de M bits et l'appliquer sur le bus,

- un multiplexeur M-en-1 recevant en entrée les M bits appliqués sur le bus, une bascule D étant interposée entre chaque ligne de bus et l'entrée correspondante du multiplexeur, et

- un ensemble série de bascules D, montées en sortie du multiplexeur,

la dernière bascule dudit ensemble série délivrant séquentiellement les bits d'information correspondant au chemin recherché, et les signaux de sélection du multiplexeur et les signaux de commande du circuit sélecteur étant directement donnés par les sorties respectives des bascules successives de cet ensemble série.

On va maintenant décrire en détail deux modes de mise en oeuvre de l'invention, en référence aux dessins annexés.

La figure 1, précitée, illustre le schéma d'implantation de l'étape de traceback de l'algorithme de Viterbi qui avait été proposé par la technique antérieure.

La figure 2 illustre un premier mode de réalisation de l'architecture selon l'invention, pour l'implantation de cette même fonction.

La figure 3 illustre un second mode de réalisation de l'architecture selon l'invention, pour l'implantation de cette même fonction.

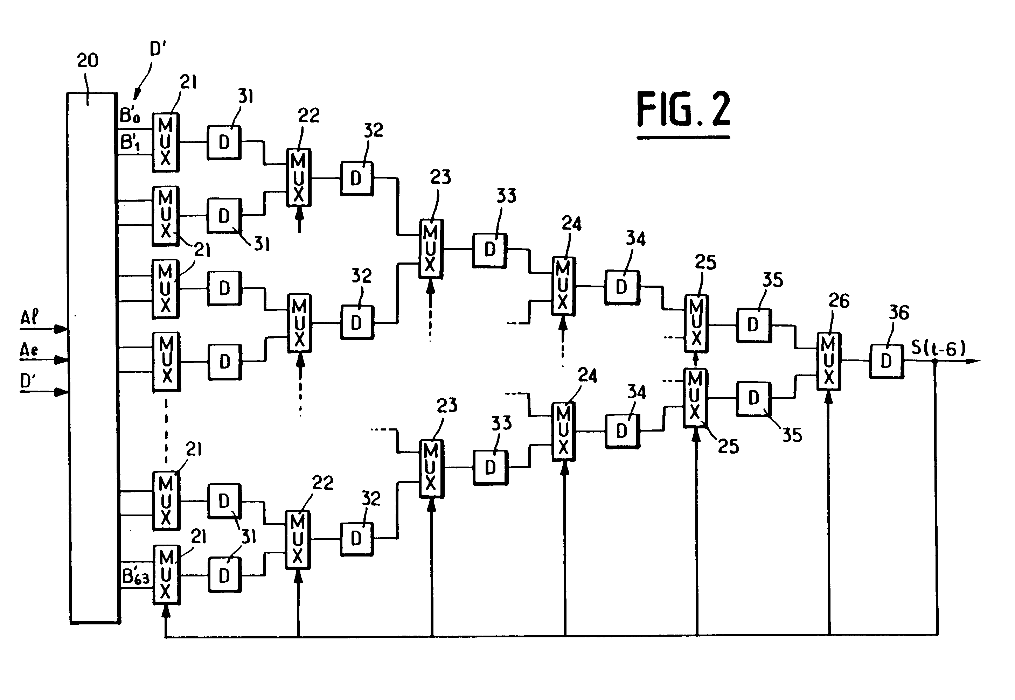

Sur la figure 2, la référence 20 désigne la mémoire de données, qui est une mémoire dont la structure est la même que la mémoire 10 de la figure 1 (c'est-à-dire une mémoire contenant trois blocs de L mots de N bits, recevant en entrée des données D', des adresses de lecture $A_l$ et des adresses d'écriture $A_e$), mais dans laquelle l'organisation du stockage des mots a été légèrement modifié.

Plus précisément, dans le schéma proposé, la mémoire est constituée de mots D', formés de $2^\nu$ bits, qui seront de la forme :

$$D' = B'_0, B'_1 \ldots B'_j \ldots B'_{2\nu-1},$$

avec $B'_j = B_i$ (le bit de la configuration conventionnelle) si et seulement si l'écriture en binaire de j est :

$$j = (A_0 \ A_1 \ \ldots \ A_{\nu-1})$$

et l'écriture en binaire de i est :

$$i = \{A_{\nu-1} \ A_{\nu-2} \ \ldots A_0\}.$$

Avec l'exemple considéré (qui n'est en aucune façon limitatif) où $N = 2^\nu = 64$, on peut donc écrire que la mémoire est constituée de mots D' de 64 bits de la forme :

$$D' = B'_0, B'_1 \ldots B'_j \ldots B'_{63},$$

avec $B_j = B_i$ (le bit de la configuration conventionnelle) si et seulement si l'écriture en binaire de j est :

$$j = \{A_0 \ A_1 \ \ldots A_5\}$$

et l'écriture en binaire de i est :

$$i = \{A_5 \ A_4 \ \ldots \ A_0\}.$$

Le mot numérique D' ainsi configuré est appliqué en entrée à une pluralité de multiplexeurs 2-en-1, qui sont donc au nombre de $N/2 = 2^{\nu-1} = 32$ dans cet exemple, qui font donc la sélection entre les N/2 premiers bits du mot D' et les N/2 derniers bits de ce même mot.

Le bit de commande de ces muitiplexeurs, le même pour tous, est le bit S(t-$\nu$) du registre de traceback (on verra par la suite comment est constitué ce registre et la manière dont est obtenu le bit nécessaire).

En d'autres termes, les N/2 multiplexeurs 21 ont pour entrées respectives les bits $B_i$ et $B_{i+2^{\nu-1}}$, avec $0 \leq i \leq (2^{\nu-1}-1)$, et ont pour commande commune S(t-$\nu$). Ils délivrent en sortie un bit que l'on notera $B_i^{(1)}$, avec i = $\{0 \ldots (2^{\nu-1}-1)\}$.

La sortie de chacun de ces multiplexeurs est appliquée à une bascule D respective 31, qui constituent le premier étage du registre de traceback. Le nombre de ces bascules 31 qui, en parallèle, constituent le premier étage du registre de traceback est bien entendu le même que celui (N/2 = 32) des multiplexeurs.

Les sorties respectives des bascules 31 sont appliquées à une seconde pluralité de multiplexeurs 2-en-1, référencés 22, au nombre de $N/4 = 2^{v-2} = 16$ dans cet exemple, qui font la sélection entre la première et la deuxième moitié du groupe de N/2 bits $B_i^{(1)}$ sélectionnés à l'étage précédent.

Ces N/4 multiplexeurs 22 ont pour entrées respectives les bits $B_i^{(1)}$ et $B_{i+2}v-2^{(1)}$, avec $0 \leq i \leq (2^{v-2}-1)$, et ont pour commande commune le bit S(t-v) du registre de traceback - qui est donc la même commande que les multiplexeurs 21 de l'étage précédent (cette propriété résultant de la présence de la bascule intercalaire 31, qui a retardé d'une phase d'horloge le signal appliqué). Ils délivrent en sortie un bit que l'on notera $B_i^{(2)}$, avec i = {0 ... $(2^{v-2}-1)$}.

Les bits de sortie $B_i^{(2)}$ de ces N/4 multiplexeurs 22 sont appliqués à N/4 bascules D respectives 32 constituant, prises globalement, le second étage du registre de traceback.

Les étages suivants sont configurés de la même manière, avec à chaque fois réduction de moitié du nombre des composants. Dans l'exemple illustré, le troisième étage comprend N/8 = 8 multiplexeurs 23 et N/8 = 8 bascules D 33, le quatrième étage comprend N/16 = 4 multiplexeurs 24 et N/16 = 4 bascules D 34, et le cinquième étage comprend N/32 = 2 multiplexeurs 25 et N/32 = 2 bascules D 35. Tous ces multiplexeurs 2-en-1 sont commandés par le même bit S(t-v).

Le sixième et dernier étage ne comprend plus qu'un seul multiplexeur 2-en-1 dont la commande est, comme pour tous les autres multiplexeurs, le bit S(t-v), qui sera le bit issu du dernier étage du registre de traceback, constitué par une bascule unique 36 disposée en sortie en ce dernier multiplexeur, cette bascule délivrant d'ailleurs également le bit d'information recherché.

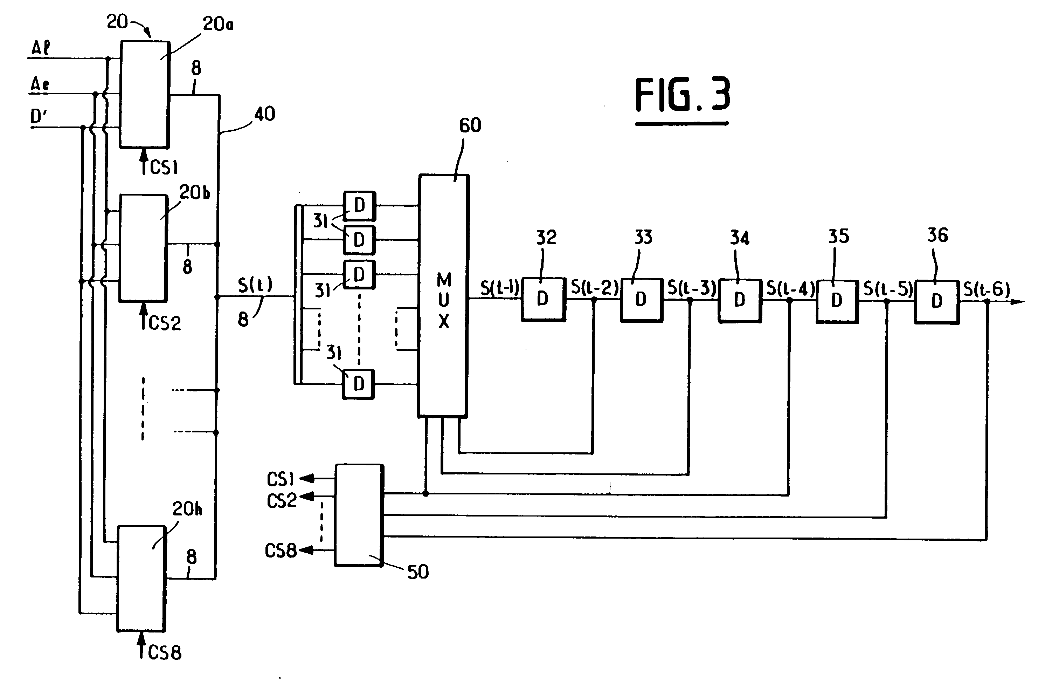

On a représenté sur la figure 3 une autre forme de réalisation, permettant de réduire le nombre de multiplexeurs et de bascules, tout en conservant une vitesse de traitement suffisante.

Dans ce circuit, au lieu d'imbriquer complètement les multiplexeurs et les étages du registre de traceback comme dans le cas de la figure 2, on ne ramène en amont des circuits de muitiplexage que le premier étage du registre de traceback, les autres étages étant configurés en un bloc homogène.

À cet effet, on fractionne la mémoire 20 en une pluralité de blocs 20a, 20b, ... 20h, stockant chacun des mots de 8 bits par exemple, et dont les sorties disposent d'un état à haute impédance (c'est-à-dire que l'on peut sélectionner isolément, par une commande externe, l'un ou l'autre de ces différents blocs) et sont reliées à un bus commun 40, de 8 bits de large. Dans l'exemple illustré, on aura donc 8 blocs de 8 bits ainsi montés en parallèle.

Un décodeur d'adresse 50 positionne en mode actif un seul des blocs, et tous les autres en état haute impédance (signaux de sélection CS1 ... CS8).

Les huit bits présents sur le bus 40 sont alors appliqués à un ensemble de huit bascules 31 constituant le premier étage du registre de traceback, et les sorties de ces bascules sont appliquées à un multiplexeur 8-en-1, référencé 60, délivrant sur sa sortie unique le bit d'information S(t-1).

En aval, on trouve les n-1 étages restants du registre de traceback, constitués de bascules 32 ... 36 (au nombre de cinq dans l'exemple considéré) la dernière bascule délivrant le bit d'information S(t-6) recherché.

Le multiplexeur 8-en-1 est commandé par les bits S(t-4), S(t-3), S(t-2) des trois étages du registre à décalage situés immédiatement en aval du multiplexeur, de manière à sélectionner le bit utile parmi les 8 bits S(t) présélectionnés.

Le décodeur d'adresse, quant à lui, est commandé par les bits S(t-v), S(t-v+1) ... S(t-4), à savoir les bits S(t-4), S(t-5) et S(t-6) des trois derniers étages du registre de traceback, dans l'exemple considéré.

En ce qui concerne le stockage des données dans les différents blocs constituant la mémoire 20, le bloc 20a contient les bits $B_0$, $B_8$, $B_{16}$, $B_{24}$, $B_{32}$, $B_{40}$, $B_{48}$ et $B_{56}$, le second bloc 20b contient les bits $B_1$, $B_9$, ...$B_{57}$, et ainsi de suite, le huitième bloc 20h contenant les bits $B_7$, $B_{15}$, ...$B_{63}$.

Dans l'un ou l'autre des modes de réalisation, le circuit de l'invention procure un gain considérable sur la vitesse d'exécution de l'algorithme de traceback de Viterbi.

En pratique le gain de vitesse ainsi obtenu est dans un rapport pouvant aller, suivant le nombre d'états du codeur, de 2 à 10 par rapport aux circuits conventionnels proposés, correspondant au schéma de la figure 1. Typiquement, pour un nombre élevé d'états du codeur (64 états, comme dans les exemples considérés), le gain en vitesse est de l'ordre de 3 à 4.

## Revendications

1. Un circuit de décodage de codes convolutionnels, pour l'exécution de l'étape d'un algorithme de Viterbi consistant à explorer en sens inverse une pluralité de chemins d'un treillis représentatif d'un diagramme des transitions possibles résultant d'un codage par un codeur à v bascules, chaque noeud du treillis étant représenté par un mot de $N = 2^v$ bits, ce circuit opérant de manière à sélectionner, parmi une pluralité de chemins survivants possibles, celui présentant la métrique la plus faible, de manière à reconstituer ainsi le chemin du treillis effectivement décrit lors du codage et retrouver la séquence de bits d'information ayant provoqué le parcours de ce chemin, ledit circuit comprenant une mémoire (20) stockant une pluralité desdits mots (D') de $N = 2^v$ bits

caractérisé en ce qu'il comprend,

en sortie de cette mémoire, un montage en cascade de $^v$ groupes de multiplexeurs 2-en-1 (21, 22, 23, 24, 25, 26), réduisant progressivement les $2^v$ sorties de la mémoire en une sortie unique, une bascule D (31, 32, 33, 34, 35, 36) étant disposée en sortie de chaque multiplexeur, la dernière bascule, unique, la plus en aval (36) délivrant séquentiellement les bits d'information (S(t-6)) correspondant au chemin recherché, et le signal de sélection de chaque multiplexeur étant directement donné par la sortie de cette dernière bascule.

2.  Un circuit de décodage de codes convolutionnels, pour l'exécution de l'étape d'un algorithme de Viterbi consistant à explorer en sens inverse une pluralité de chemins d'un treillis représentatif d'un diagramme des transitions possibles résultant d'un codage par un codeur à v bascules, chaque noeud du treillis étant représenté par un mot de N = $2^v$ bits, ce circuit opérant de manière à sélectionner, parmi une pluralité de chemins survivants possibles, celui présentant la métrique la plus faible, de manière à reconstituer ainsi le chemin du treillis effectivement décrit lors du codage et retrouver la séquence de bits d'information ayant provoqué le parcours de ce chemin,

caractérisé en ce qu'il comprend :

-  une mémoire (20) stockant une pluralité desdits mots de N = $2^v$ bits sous forme de N/M blocs (20a, 20b ... 20h) sélectionnables distincts de M bits chacun, M étant un sous-multiple de N de la forme M = $2^\mu$, les sorties de chaque bloc étant appliqués sur un bus commun (40) de M bits de large,

-  un circuit sélecteur (50), pour sélectionner (CS1, CS2, ... CS8) l'un desdits blocs de M bits et l'appliquer sur le bus,

-  un multiplexeur M-en-1 (60) recevant en entrée les M bits appliqués sur le bus, une bascule D (31) étant interposée entre chaque ligne de bus et l'entrée correspondante du multiplexeur, et

-  un ensemble série de bascules D (32, 33, 34, 35, 36), montées en sortie du multiplexeur, la dernière bascule (36) dudit ensemble série délivrant

séquentiellement les bits d'information (S(t-6)) correspondant au chemin recherché,

les signaux de sélection du multiplexeur (S(t-2), S(t-3), S(t-4)) et les signaux de commande du circuit sélecteur (S(t-4), S(t-5), S(t-6)) étant directement donnés par les sorties respectives (S(t-2), S(t-3), S(t-4), S(t-5), S(t-6)) des bascules successives de cet ensemble série.

## Patentansprüche

1.  Schaltung zur Dekodierung von Konvolutionskodes und für die Durchführung des Schritts aus einem Viterbi-Algorithmus, bei dem in umgekehrter Richtung zahlreiche Wege eines Netzes untersucht werden, das ein Diagramm der möglichen Übergänge aufgrund einer Kodierung durch einen Kodierer mit v Kippstufen darstellt, wobei jeder Knoten des Netzes durch ein Wort von N = $2^v$ Bits dargestellt wird und die Schaltung so arbeitet, daß aus einer Vielzahl von möglichen überlebenden Wegen derjenige ausgewählt wird, der die niedrigste Metrik bietet, so daß der Weg, der bei der Kodierung tatsächlich durch das Netz beschritten wurde, wiedergebildet wird und die Folge von Informationsbits gefunden wird, die den Verlauf dieses Wegs bestimmt hat, wobei die Schaltung einen Speicher (20) zur Speicherung zahlreicher Wörter (D') von je N = $2^v$ Bits enthält, dadurch gekennzeichnet, daß die Schaltung weiter am Ausgang des Speichers eine Kaskadenanordnung von v Gruppen von Multiplexern "von 2 nach 1" (21, 22, 23, 24, 25, 26) enthält, die progressiv die $2^v$ Ausgänge des Speichers auf einen einzigen Ausgang reduzieren, wobei eine Kippstufe vom Typ D (31, 32, 33, 34, 35, 36) am Ausgang jedes Multiplexers liegt, und daß die letzte, eine Kippstufe (36) am Ende nacheinander die Informationsbits (S(t-6)) entsprechend dem gesuchten Weg liefert, wobei das Auswahlsignal jedes Multiplexers unmittelbar durch den Ausgang dieser letzten Stufe gegeben wird.

2.  Schaltung zur Dekodierung von Konvolutionskodes und für die Durchführung des Schritts aus einem Viterbi-Algorithmus, bei dem in umgekehrter Richtung zahlreiche Wege eines Netzes untersucht werden, das ein Diagramm der möglichen Übergänge aufgrund einer Kodierung durch einen Kodierer mit v Kippstufen darstellt, wobei jeder Knoten des Netzes durch ein Wort von N = $2^v$ Bits dargestellt wird und die Schaltung so arbeitet, daß aus einer Vielzahl von möglichen überlebenden Wegen derjenige ausgewählt wird, der die niedrigste Metrik bietet, so daß der Weg, der bei der Kodierung tatsächlich durch das Netz beschritten wurde, wiedergebildet wird und die Folge von Informationsbits gefunden wird, die den Verlauf dieses Wegs bestimmt hat, dadurch gekennzeichnet, daß sie enthält:

-  einen Speicher (20), der zahlreiche Wörter von je N = $2^v$ Bits in Form von N/M getrennten und wählbaren Blöcken (20a, 20b, ... 20h) von je M Bits speichert, wobei M ein Untervielfaches von N der Form M = $2^\mu$ ist und die Ausgänge jedes Blocks an einen gemeinsamen Bus (40) einer Kapazität von M Bits angelegt sind,

- eine Selektorschaltung (50), um einen der Blökke (CS1, CS2, ... CS8) mit M Bits auszuwählen und an den Bus anzulegen,
- einen Multiplexer "von M nach 1" (60), der eingangsseitig die M an den Bus angelegten Bits empfängt, wobei eine Kippstufe vom Typ D (31) zwischen jeder Busleitung und den entsprechenden Eingang des Multiplexers eingefügt ist,
- und eine Serienanordnung von Kippstufen des Typs D (32, 33, 34, 35, 36), die an den Ausgang des Multiplexers angeschlossen ist,

wobei die letzte Kippstufe (36) der Serienanordnung die Folge von Informationsbits (S(t-6)) entsprechend dem gesuchten Weg liefert und die Selektionssignale des Multiplexers (S(t-2), S(t-3), S(t-4)) und die Steuersignale (S(t-4), S(t-5), S(t-6)) der Selektorschaltung unmittelbar durch die entsprechenden Ausgänge (S(t-2), S(t-3), S(t-4), S(t-5), S(t-6)) der aufeinanderfolgenden Kippstufen dieser Serienanordnung gegeben sind.

## Claims

1. A convolutional code decoding circuit for executing the stage of a Viterbi algorithm which involves reverse scanning of a plurality of paths of a trellis representing a diagram of possible transitions resulting from encoding by an encoder comprising $\nu$ flip-flops, each node of the trellis being represented by a word of $N = 2^\nu$bits, said circuit selecting from a plurality of possible survivor paths that having the lowest metric, so as to reconstitute the trellis path determined during encoding and to recover the sequence of information bits causing said path to be adopted, said circuit comprising a memory (20) storing a plurality of said words (D') of $N = 2^\nu$ bits, characterised in that it comprises,

   - connected to the output of said memory, a cascade of $\nu$ groups of 2-in-1 multiplexers (21, 22, 23, 24, 25, 26) progressively combining the $2^\nu$ outputs of the memory into a single output, a D flip-flop (31, 32, 33, 34, 35, 36) being provided at the output of each multiplexer, the single final flip-flop (36) outputting in sequence the information bits (S(t - 6)) representing the required path and the select signal for each multiplexer being the output of said final flip-flop.

2. A convolutional code decoding circuit for executing the stage of a Viterbi algorithm which involves reverse scanning of a plurality of paths of a trellis representing a diagram of possible transitions resulting from encoding by an encoder comprising

$\nu$ flip-flops, each node of the trellis being represented by a word of $N=2^\nu$ bits, said circuit selecting, from a plurality of possible survivor paths, that having the lowest metric, so as to reconstitute the trellis path determined during encoding and to recover the sequence of information bits causing said path to be adopted, characterised in that it comprises:

- a memory (20) storing a plurality of said words of $N = 2^\nu$ bits in the form of N/M separately selectable blocks (20a, 20b 20h) each of M bits where M is a submultiple of N in the form $M = 2^\mu$, the outputs of each block being applied to a common bus (40) M bits wide,
- a circuit (50) for selecting (CS1, CS2, ..., CS8) one of said blocks of M bits and applying it to the bus,
- an M-in-1 multiplexer (60) receiving on its input side the M bits supplied to the bus, a D flip-flop (31) being provided between each bus line and the corresponding input of the multiplexer, and
- a series combination of D flip-flops (32, 33, 34, 35, 36) connected to the output of the multiplexer,

the final flip-flop (36) of said series combination outputting sequentially the information bits (S(t - 6)) representing the required path, the select signals (S(t - 2), S(t - 3), S(t - 4)) of the multiplexer and the command signals (S(t - 4), S(t - 5), S(t - 6)) of the selector circuit being the respective outputs (S(t - 2), S(t - 3), S(t - 4), (S(t - 5), (S(t - 6)) of the successive flip-flops of said series combination.

FIG.1

EP 0 463 598 B1

FIG. 2

EP 0 463 598 B1

FIG.3

EP 0 463 598 B1